# EUROPÄISCHE PATENTSCHRIFT

(11) **EP 2 609 632 B1**
(45) Veröffentlichungstag und Bekanntmachung des Hinweises auf die Patenterteilung: **02.10.2019**
(21) Anmeldenummer: 11748340.4
(22) Anmeldetag: 11.08.2011
(51) Int. Cl.: H01L 33/00, H01L 33/12, H01L 29/20

(54) **HALBLEITERBAUELEMENT UND VERFAHREN ZUR HERSTELLUNG EINES HALBLEITERBAUELEMENTS**
SEMICONDUCTOR COMPONENT AND METHOD FOR PRODUCING A SEMICONDUCTOR COMPONENT
COMPOSANT SEMI-CONDUCTEUR ET PROCÉDÉ DE FABRICATION D'UN COMPOSANT SEMI-CONDUCTEUR

(30) Priorität: 26.08.2010 DE 102010035489
(43) Veröffentlichungstag der Anmeldung: 03.07.2013
(73) Patentinhaber: OSRAM Opto Semiconductors GmbH, 93055 Regensburg (DE)
(72) Erfinder: STAUSS, Peter, 93051 Regensburg (DE); DRECHSEL, Philipp, 93098 Mintraching (DE); HERTKORN, Joachim, 93087 Alteglofsheim (DE)
(74) Vertreter: Epping - Hermann - Fischer
(86) Internationale Anmeldenummer: PCT/EP2011/063883
(87) Internationale Veröffentlichungsnummer: WO 2012/025397

(56) Entgegenhaltungen:
- DE-A1-102006 008 929
- JP-A- 2009 231 302
- JP-A- 2009 283 895
- WATANABE A ET AL: "The growth of single crystalline GaN on a Si substrate using AIN as an intermediate layer", JOURNAL OF CRYSTAL GROWTH, ELSEVIER, AMSTERDAM, NL, Bd. 128, Nr. 1-4, 1. März 1993 (1993-03-01), Seiten 391-396, XP024438646, ISSN: 0022-0248, DOI: 10.1016/0022-0248(93)90354-Y [gefunden am 1993-03-01]
- BLÃ SING J ET AL: "Oxygen induced strain field homogenization in AlN nucleation layers and its impact on GaN grown by metal organic vapor phase epitaxy on sapphire: An x-ray diffraction study", JOURNAL OF APPLIED PHYSICS, AMERICAN INSTITUTE OF PHYSICS. NEW YORK, US, Bd. 105, Nr. 3, 3. Februar 2009 (2009-02-03), Seiten 33504-33504, XP012119699, ISSN: 0021-8979, DOI: 10.1063/1.3074095
- KUHN B ET AL: "An oxygen doped nucleation layer for the growth of high optical quality GaN on sapphire", PHYSICA STATUS SOLIDI (A). APPLIED RESEARCH, BERLIN, DE, Bd. 188, Nr. 2, 16. Juli 2001 (2001-07-16) , Seiten 629-633, XP002538990, ISSN: 0031-8965, DOI: _
- TRIPATHY S ET AL: "GaN-based microdisk light emitting diodes on (111)-oriented nanosilicon-on-insulator templates", JOURNAL OF APPLIED PHYSICS, AMERICAN INSTITUTE OF PHYSICS. NEW YORK, US, Bd. 104, Nr. 5, 3. September 2008 (2008-09-03), Seiten 53106-53106, XP012117346, ISSN: 0021-8979, DOI: 10.1063/1.2973684
- HERTKORN ET AL: "Optimization of nucleation and buffer layer growth for improved GaN quality", JOURNAL OF CRYSTAL GROWTH, ELSEVIER, AMSTERDAM, NL, Bd. 308, Nr. 1, 2. Oktober 2007 (2007-10-02), Seiten 30-36, XP022283179, ISSN: 0022-0248, DOI: 10.1016/J.JCRYSGRO.2007.07.056
- JAMIL M ET AL: "Mechanism of large area dislocation defect reduction in GaN layers on AlNâ Si (111) by substrate engineering", JOURNAL OF APPLIED PHYSICS, AMERICAN INSTITUTE OF PHYSICS. NEW YORK, US, Bd. 102, Nr. 2, 16. Juli 2007 (2007-07-16) , Seiten 23701-23701, XP012101251, ISSN: 0021-8979, DOI: 10.1063/1.2753706
- DADGAR A ET AL: "Growth of blue GaN LED structures on 150-mm Si(111)", JOURNAL OF CRYSTAL GROWTH, ELSEVIER, AMSTERDAM, NL, Bd. 297, Nr. 2, 29. Dezember 2006 (2006-12-29), Seiten 279-282, XP025157375, ISSN: 0022-0248, DOI: 10.1016/J.JCRYSGRO.2006.09.032 [gefunden am 2006-12-29]
- DADGAR A ET AL: "Reduction of stress at the initial stages of GaN growth on Si(111)", APPLIED PHYSICS LETTERS, AIP, AMERICAN INSTITUTE OF PHYSICS, MELVILLE, NY, US, Bd. 82, Nr. 1, 6. Januar 2003 (2003-01-06) , Seiten 28-30, XP012033431, ISSN: 0003-6951, DOI: 10.1063/1.1534940
- LIN KUNG-LIANG ET AL: "Growth of GaN film on 150mm Si (111) using multilayer AlNâ AlGaN buffer by metal-organic vapor phase epitaxy method", APPLIED PHYSICS LETTERS, AIP, AMERICAN INSTITUTE OF PHYSICS, MELVILLE, NY, US, Bd. 91, Nr. 22, 28. November 2007 (2007-11-28), Seiten 222111-222111, XP012104555, ISSN: 0003-6951, DOI: 10.1063/1.2818675

## Beschreibung

Diese Patentanmeldung beansprucht die Priorität der deutschen Patentanmeldung 10 2010 035 489.9.

Es werden ein Halbleiterbauelement sowie ein Verfahren zur Herstellung eines Halbleiterbauelements angegeben. Verbindungshalbleitermaterialien, insbesondere sogenannte Gruppe-III-V-Verbindungshalbleiter sind von großer Bedeutung, beispielsweise für die Herstellung von Licht emittierenden Dioden (LEDs). Insbesondere GaN-basierte LEDs ermöglichen die Erzeugung von Licht bis in den ultravioletten Spektralbereich hinein. Zur Herstellung von solchen LEDs werden geeignete Schichtfolgen, beispielsweise aus GaN-haltigen Verbindungshalbleitermaterialien, auf einem Substrat aufgewachsen. Als Substratmaterialien werden für ein epitaktisches Wachstum üblicherweise Saphir oder Siliziumkarbid verwendet, die eine Gitterstruktur aufweisen, die an die Gitterstruktur der Verbindungshalbleitermaterialien angepasst ist. Der Nachteil dieser Substratmaterialien liegt aber beispielsweise in deren hohen Preis.

Ein günstigeres Substratmaterial, das in der Halbleitertechnologie vielfach genutzt wird, ist Silizium. Beim Aufwachsen insbesondere nitridischer Verbindungshalbleitermaterialien auf Siliziumsubstraten treten jedoch Verspannungen aufgrund unterschiedlicher Gitterparameter der beteiligten Materialien auf, die zu einer Herabsetzung der Kristallqualität der aufgewachsenen Schichten führen. Das Dokument XP24438646 "The growth of single crystalline GaN on a Si substrate using AIN as an intermediate layer." A. Watanabe et al,JOURNAL OF CRYSTAL GROWTH 128 (1993, ELSEVIER, AMSTERDAM, NL, beschreibt ein Verfahren zum Aufwachsen von kristallinen GaN Schichten auf einem Si-Substrate, bei dem eine AlN Schicht als Nukleationsschicht verwendet wird.

Das Dokument XP12119699,"Oxygen induced strain field homogenization in AlN nucleation layers and its impact on GaN grown by metal organic vapor phase epitaxy on sapphire: An x-ray diffraction study." Bläsing J. et al, JOURNAL OF APPLIED PHYSICS, AMERICAN INSTITUTE OF PHYSICS. NEW YORK, US, vol 105, 2009 beschreibt ein Verfahren zum Aufwachsen von kristallinen GaN Schichten auf einem Si-Substrate, bei dem eine AlN Schicht mit einem 0.3% Sauerstoffanteil im Stickstoff, als eine Nukleationsschicht verwendet wird. Das Dokument JP200923102 A beschreibt ein Verfahren zum Aufwachsen von kristallinen GaN Schichten auf einem Si-Substrate, bei dem eine Sauerstoff dotierte AlN Schicht als eine Übergangsschicht verwendet wird.

Eine Aufgabe zumindest einiger Ausführungsformen ist es, ein Halbleiterbauelement mit einer Halbleiterschichtenfolge auf einem Substrat anzugeben. Eine weitere Aufgabe zumindest einiger Ausführungsformen ist es, ein Verfahren zur Herstellung eines Halbleiterbauelements anzugeben.

Diese Aufgaben werden durch einen Gegenstand und ein Verfahren mit den Merkmalen der unabhängigen Patentansprüche gelöst. Vorteilhafte Ausführungsformen und Weiterbildungen des Gegenstands und des Verfahrens sind in den abhängigen Ansprüchen gekennzeichnet.

Ein Halbleiterbauelement gemäß einer Ausführungsform weist insbesondere eine Halbleiterschichtenfolge aus einem nitridischen Verbindungshalbleitermaterial auf, das auf einem Substrat aufgebracht ist.

Ein Verfahren zur Herstellung eines Halbleiterbauelements umfasst gemäß einer Ausführungsform insbesondere das Aufbringen einer Halbleiterschichtenfolge aus einem nitridischen Verbindungshalbleitermaterial auf einem Substrat.

Die nachfolgende Beschreibung von Ausführungsformen und Merkmalen zum Bauelement sowie zum Verfahren zur Herstellung des Bauelements bezieht sich gleichermaßen auf das Halbleiterbauelement wie auch auf das Verfahren zur Herstellung des Halbleiterbauelements.

"Auf einem nitridischen Verbindungshalbleitermaterial basierend" beziehungsweise "aus einem nitridischen Verbindungshalbleitermaterial" bedeutet hier und im Folgenden, dass die Halbleiterschichtenfolge eine epitaktisch auf dem Substrat abgeschiedene Schichtenfolge ist, die zumindest eine Schicht aus einem Nitrid-III-V-Verbindungshalbleitermaterial aufweist, vorzugsweise AlₙGaₘIn₁₋ₘ₋ₙN, wobei 0 ≤ n ≤ 1, 0 ≤ m ≤ 1 und n + m ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des AlₙGaₘIn₁₋ₘ₋ₙN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Gemäß einer weiteren Ausführungsform wird die Halbleiterschichtenfolge auf dem Substrat mittels eines epitaktischen Aufwachsverfahrens, besonders bevorzugt mittels eines MOVPE-Verfahrens oder auch mittels eines MBE-Verfahrens, aufgewachsen.

Gemäß einer weiteren Ausführungsform weist das Substrat eine der Halbleiterschichtenfolge zugewandte Silizium-Oberfläche auf. Das bedeutet insbesondere, dass die Halbleiterschichtenfolge auf der Silizium-Oberfläche des Substrats aufgewachsen ist.

Gemäß einer weiteren Ausführungsform weist das Substrat an der Silizium-Oberfläche eine (111)-Ebene auf, das bedeutet, dass die Silizium-Oberfläche des Substrats eine (111)-Ebene einer Silizium-Kristallschicht ist. Eine Silizium-Oberfläche dieser Orientierung zeichnet sich gegenüber anderen Orientierungen durch eine erhöhte obere Fließgrenze aus. Weiterhin eignet sich eine (111)-Ebene aufgrund ihrer sechszähligen Symmetrie besonders für die Abscheidung von nitridischen Verbindungshalbleitermaterialien.

Das Substrat kann insbesondere als Silizium-Volumen-Substrat oder als SOI-Substrat ("silicon on insulator substrate") ausgebildet sein.

Gemäß einer weiteren Ausführungsform weist die Halbleiterschichtenfolge einen aktiven Bereich auf, der die eigentliche Funktionalität des Halbleiterbauelements bereitstellt. Beispielsweise kann der aktive Bereich eine Schichtenfolge aus p- und n-dotierten Schichten aufweisen, zwischen denen eine aktive Schicht angeordnet ist, die zur Erzeugung und/oder zum Empfangen von Strahlung vorgesehen ist. In dieser Ausführungsform ist das Halbleiterbauelement als optoelektronisches Bauelement ausgeführt. Alternativ oder zusätzlich kann das Halbleiterbauelement als ein, vorzugsweise aktives, elektronisches Halbleiterbauelement ausgebildet sein, beispielsweise als Transistor, etwa als Transistor mit hoher Elektronenbeweglichkeit ("high-electron mobility transistor", HEMT) oder als Bipolartransistor mit einem Heteroübergang ("hetero-junction bipolar transistor", HBT). Auch in diesem Fall weist der aktive Bereich der Halbleiterschichtenfolge geeignete Schichten auf, die die Funktionalität des Halbleiterbauelements bestimmen.

Verglichen mit anderen bekannten Halbleiterbauelementen auf Silizium-Basis, bei denen die funktionalen Bereiche des Bauelements typischerweise zumindest teilweise in das Silizium-Substrat integriert sind, befindet sich beim hier beschriebenen Halbleiterbauelement der aktive Bereich und damit der die Funktionalität bestimmende Bereich außerhalb des Substrats.

Gemäß einer weiteren Ausführungsform weist die Halbleiterschichtenfolge zwischen dem Substrat und dem aktiven Bereich zumindest eine Zwischenschicht aus einem sauerstoffdotierten AlN-Verbindungshalbleitermaterial auf. Insbesondere wird bei der Herstellung des Halbleiterbauelements auf das Substrat mit der Silizium-Oberfläche zuerst die Zwischenschicht aus dem sauerstoffdotierten AlN-Verbindungshalbleitermaterial und anschließend der aktive Bereich der Halbleiterschichtenfolge aufgebracht.

Gemäß einer weiteren Ausführungsform weist das sauerstoffdotierte AlN-Verbindungshalbleitermaterial zusätzlich zu Al und N als Wirtskristallbestandteile noch Ga und/oder In auf. Insbesondere kann das AlN-Verbindungshalbleitermaterial AlGaN aufweisen mit einem Ga-Anteil von kleiner oder gleich 50%, bevorzugt mit einem Ga-Anteil von kleiner oder gleich 20% und besonders bevorzugt mit einem Ga-Anteil von kleiner oder gleich 10%, jeweils bezogen auf die Gruppe-III-Elemente.

Gemäß einer weiteren Ausführungsform ist das sauerstoffdotierte AlN-Verbindungshalbleitermaterial Ga- und In-frei und weist als Wirtskristallelemente abgesehen von der Dotierung lediglich Al und N auf. Mit umfasst von den Begriffen "Ga-frei" und "In-frei" sind jedoch auch AlN-Verbindungshalbleitermaterialien, die Ga und/oder In und/oder weitere Elemente in Form von Verunreinigungen aufweisen, die beispielsweise prozessbedingt sein können.

Es hat sich gezeigt, dass durch die Zugabe von Sauerstoff zu einer Zwischenschicht zwischen dem aktiven Bereich und dem Substrat, die auf einem AlN-Verbindungshalbleitermaterial basiert, eine hohe Kristallqualität der darüber aufgewachsenen Schichten des aktiven Bereichs, die mit einer vergleichsweise hohen Dicke, etwa 3 µm oder mehr, aufgewachsen werden, erreicht werden kann. Insbesondere kann dadurch ein Aufwachsen des aktiven Bereichs mit hoher kristalliner Qualität und Homogenität erfolgen. Insbesondere kann die Qualität und Homogenität in lateraler Richtung, also senkrecht zur Abscheiderichtung, erreicht werden. Eine erhöhte Kristallqualität und Homogenität kann beispielsweise anhand von reduzierten Halbwertsbreiten von kristallografischen Röntgenreflexen, beispielsweise durch gemessene Rocking-Kurven der (002)-, (102)- und (201)-Reflexe, festgestellt werden. Im Vergleich zu bekannten Halbleiterbauelementen, bei denen nitridische Verbindungshalbleitermaterialien auf Siliziumsubstraten aufgewachsen werden, konnten die Erfinder im vorliegenden Fall für die hier beschriebenen Ausführungsformen und Ausführungsbeispiele eine derartige Verbesserung der kristallinen Qualität und der Homogenität feststellen.

Gemäß der Erfindung ist der Sauerstoffgehalt größer oder gleich 1% und kleiner oder gleich 5% und kann bevorzugt kleiner oder gleich 3% sein. Hier und im Folgenden bezeichnet ein Sauerstoffgehalt der Zwischenschicht gemessen in Prozent den Anteil der Sauerstoffatome in der Zwischenschicht in Atom-% relativ zur Anzahl der Atome des Wirtskristalls der Zwischenschicht, also beispielsweise der Al- und N-Atome.

Es hat sich gezeigt, dass die Gitterkonstante der Zwischenschicht durch den zugefügten Sauerstoff mit Vorteil derart verändert werden kann, dass die über der Zwischenschicht aufgewachsenen Schichten des aktiven Bereichs der Halbleiterschichtenfolge mit einer verbesserten kristallinen Qualität und Homogenität abgeschieden werden können.

Zur Herstellung der Zwischenschicht kann gemäß einer weiteren Ausführungsform während des Aufwachsverfahrens eine sauerstoffhaltige Verbindung bereitgestellt werden, die neben anderen Ausgangsmaterialien zum Aufwachsen der Halbleiterschichtenfolge und insbesondere der Zwischenschicht der Aufwachskammer zugeführt wird. Beispielsweise kann einem bereitgestellten Trägergas, etwa einem Stickstoffgas, ein geeignet gewählter Anteil an Sauerstoffgas zugefügt werden. Besonders bevorzugt wird zur Herstellung der Zwischenschicht eine sauerstoffhaltige Metallorganylverbindung bereitgestellt und der Aufwachskammer zugeführt. Mit besonderem Vorteil kann dabei als sauerstoffhaltige Metallorganylverbindung Diethylaluminiumethoxid (DEAlO) bereitgestellt werden. Die Erfinder haben herausgefunden, dass eine derartige Metallorganylverbindung im Vergleich zu anderen sauerstoffhaltigen Ausgangsmaterialien eine besonders einfache und qualitativ hochwertige Herstellung der Zwischenschicht und damit auch der darüber aufgebrachten weiteren Halbleiterschichtenfolge ermöglicht.

Gemäß einer weiteren Ausführungsform weist die Zwischenschicht eine Dicke von größer oder gleich 5 nm auf. Je nach Dotierungsgrad und Anordnung der Zwischenschicht in der Halbleiterschichtenfolge kann die Zwischenschicht auch eine Dicke von größer oder gleich 10 nm, größer oder gleich 15 nm oder auch größer oder gleich 20 nm aufweisen. Weiterhin kann die Zwischenschicht eine Dicke von kleiner oder gleich 300 nm, je nach Anordnung und Dotierungsgrad auch eine Dicke von kleiner oder gleich 200 nm, kleiner oder gleich 100 nm, kleiner oder gleich 50 nm, kleiner oder gleich 30 nm oder sogar kleiner oder gleich 20 nm aufweisen.

Insbesondere kann die Zwischenschicht als Teil eines Zwischenbereichs auf dem Substrat mit der Silizium-Oberfläche aufgebracht werden. Der Zwischenbereich, der als Teil der Halbleiterschichtenfolge zwischen dem aktiven Bereich und dem Substrat aufgebracht wird, weist eine Nukleations- bzw. Ankeimschicht auf. Weiterhin kann der Zwischenbereich eine Übergangsschicht, die beispielsweise als Schichtenfolge ausgebildet ist, in der der Ga-Gehalt schrittweise oder kontinuierlich von Schicht zu Schicht erhöht wird, und darüber eine Verspannungsschicht, die beispielsweise AlN-und/oder AlGaN-Zwischenschichten aufweist, die abwechselnd mit GaN überwachsen werden, aufweisen.

Gemäß einer nicht beanspruchten Ausführungsform ist die Zwischenschicht als Nukleationsschicht ausgebildet. Dabei kann die Zwischenschicht insbesondere als eine erste Schicht des Zwischenbereichs, insbesondere als erste Nukleationsschicht, direkt auf dem Substrat, also auf der Silizium-Oberfläche des Substrats, aufgebracht werden. Es können zusätzlich noch weitere Nukleationsschichten, die beispielsweise auch aus sauerstoffdotiertem AlN-Verbindungshalbleitermaterial aufgewachsen sind, in der Halbleiterschichtenfolge enthalten sein. Die Dicke der Nukleationsschicht kann eine der vorgenannten Dicken aufweisen und weiterhin bevorzugt größer oder gleich 50 nm und kleiner oder gleich 300 nm sein, bevorzugt beispielsweise etwa 200 nm.

Gemäß einer weiteren Ausführungsform ist die Zwischenschicht als Übergangsschicht oder als Teil einer Übergangsschicht zwischen dem aktiven Bereich und dem Substrat, insbesondere zwischen dem aktiven Bereich mit einer Nukleationsschicht, ausgebildet. Das kann insbesondere auch bedeuten, dass die Übergangsschicht eine Schichtenfolge aufweist, die AlN-und/oder AlGaN-Schichten aufweist, in denen in einer Richtung vom Substrat zum aktiven Bereich hin, also in Aufwachsrichtung, der Ga-Anteil erhöht wird. Die Zwischenschicht kann dabei als die Schichtenfolge oder auch als eine oder mehrere Schichten der Schichtenfolge der Übergangsschicht ausgebildet sein.

Gemäß einer weiteren Ausführungsform kann die zumindest eine Zwischenschicht zwischen einer Übergangsschicht und dem aktiven Bereich angeordnet sein. Das kann insbesondere bedeuten, dass die Zwischenschicht direkt an den aktiven Bereich angrenzt, also an diejenigen Schichten der Halbleiterschichtenfolge, die die eigentliche Funktionalität des Halbleiterbauelements bestimmen. In diesem Fall kann die Zwischenschicht eine der vorgenannten Dicken und weiterhin insbesondere eine Dicke von bevorzugt kleiner oder gleich 50 nm, beispielsweise von 20 nm, aufweisen.

Weitere Vorteile und vorteilhafte Ausführungsformen und Weiterbildungen ergeben sich aus den im Folgenden in Verbindung mit den Figuren 1 bis 4C beschriebenen Ausführungsformen.

Es zeigen:
- Figur 1: eine schematische Darstellung eines Halbleiterbauelements gemäß einem nicht beanspruchten Ausführungsbeispiel,
- Figuren 2 und 3: schematische Darstellungen von Halbleiterbauelementen gemäß einem beanspruchten Ausführungsbeispielen und
- Figuren 4A bis 4C: schematische Darstellungen eines Verfahrens zur Herstellung eines Halbleiterbauelements gemäß einem weiteren beanspruchten Ausführungsbeispiel.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie z. B. Schichten, Bauteile, Bauelemente und Bereiche, zur besseren Darstellbarkeit und/oder zum besseren Verständnis übertrieben dick oder groß dimensioniert dargestellt sein.

In den folgenden Ausführungsbeispielen sind rein exemplarisch Halbleiterbauelemente gezeigt, die als Leuchtdiodenchips ausgebildet sind. Das bedeutet insbesondere, dass die gezeigten Halbleiterbauelemente jeweils einen aktiven Bereich aufweisen, der dazu geeignet ist, im Betrieb Licht abzustrahlen. Alternativ oder zusätzlich dazu kann der aktive Bereich der gezeigten Halbleiterbauelemente auch strahlungsempfangende Schichten aufweisen. Weiterhin können die Halbleiterbauelemente gemäß der Ausführungsbeispiele alternativ oder zusätzlich auch als elektronische Halbleiterbauelemente ausgeführt sein, also beispielsweise als Transistoren, etwa HEMT oder HBT, die entsprechend ausgebildete aktive Bereiche aufweisen.

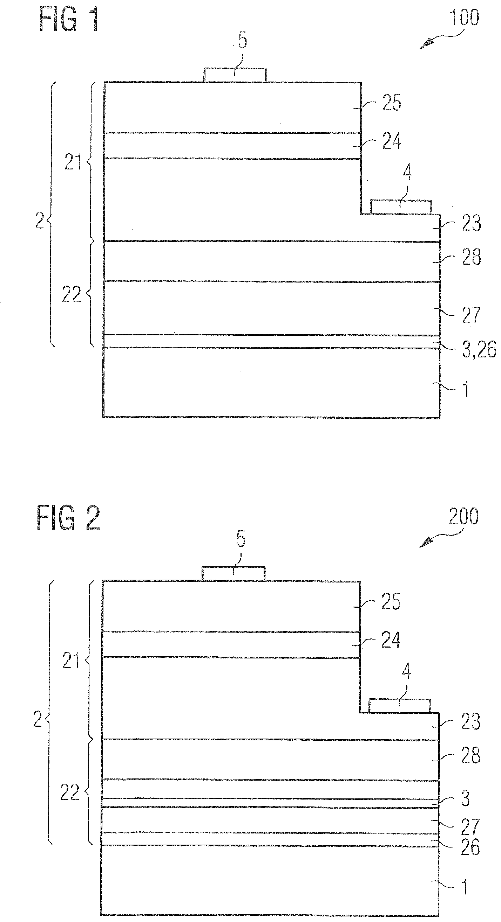

In Figur 1 ist ein Ausführungsbeispiel für ein Halbleiterbauelement 100 gezeigt, das eine Halbleiterschichtenfolge 2 auf einem Substrat 1 aufweist. Die Halbleiterschichtenfolge ist vorzugsweise epitaktisch, etwa mittels eines MOVPE- oder MBE-Verfahrens, auf dem Substrat 1 abgeschieden.

Das Substrat weist eine der Halbleiterschichtenfolge 2 zugewandte Silizium-Oberfläche auf, auf der die Halbleiterschichtenfolge 2 aufgebracht ist. Als Substrat 1 eignet sich insbesondere ein Volumen-Siliziumsubstrat. Es kann alternativ dazu aber auch ein SOI-Substrat verwendet werden. Besonders bevorzugt weist das Substrat 1 als Silizium-Oberfläche eine Oberfläche mit einer (111)-Orientierung auf. Wie im allgemeinen Teil beschrieben, eignet sich eine derartige (111)-Ebene von Silizium aufgrund einer hexagonalen Symmetrie besonders für das epitaktische Aufwachsen von nitridischen Verbindungshalbleitermaterialien. Im Vergleich zu üblichen Aufwachssubstraten für nitridische Verbindungshalbleitermaterialien wie etwa Saphir, Siliziumkarbid oder Galliumnitrid kann ein Substrat mit einer Silizium-Oberfläche großflächig und kostengünstig herstellbar und verfügbar sein.

Die Halbleiterschichtenfolge 2 basiert auf einem nitridischen Verbindungshalbleitermaterial, insbesondere auf AlₙGaₘIn₁₋ₘ₋ₙN mit 0 ≤ n ≤ 1, 0 ≤ m ≤ 1 und n + m ≤ 1. Die Halbleiterschichtenfolge 2 weist einen aktiven Bereich 21 auf, der auf einem Zwischenbereich 22 auf dem Substrat 1 aufgewachsen ist.

Der aktive Bereich 21 der Halbleiterschichtenfolge weist eine aktive Schicht 24 auf, die geeignet ist, im Betrieb des Halbleiterbauelements 100 Licht abzustrahlen. Dazu ist die aktive Schicht 24 zwischen einer ersten Halbleiterschicht 23 und einer zweiten Halbleiterschicht 24 angeordnet, die p-bzw. n-dotiert sind. Der Schichtaufbau des aktiven Bereichs 21 ist dabei rein beispielhaft gezeigt und kann weitere funktionale Schichten aufweisen.

Im Betrieb des Halbleiterbauelements können über elektrische Kontakte 4 und 5 von unterschiedlichen Seiten in die aktive Schicht 24 Ladungsträger injiziert werden, die dort unter Emission von Licht rekombinieren können.

Der aktive Bereich 21 weist bevorzugt eine Dicke von größer oder gleich 2 µm und kleiner oder gleich 8 µm auf, besonders bevorzugt größer oder gleich 3 µm und kleiner oder gleich 5 µm. Im gezeigten Ausführungsbeispiel kann der aktive Bereich insbesondere eine Dicke von etwa 4 µm oder weniger und besonders bevorzugt von größer oder gleich 1,5 µm und kleiner oder gleich 2,5 µm aufweisen. Abhängig von der Art des Halbleiterbauelements 100 und der Ausführung des aktiven Bereichs 21 der Halbleiterschichtenfolge 2 können aber auch größere oder kleinere Dicken zweckmäßig sein.

Bei einem Substrat, das einen kleineren thermischen Ausdehnungskoeffizienten aufweist als das abzuscheidende Material, wie dies im folgenden Fall für das Substrat 1 mit der Silizium-Oberfläche und die Halbleiterschichtenfolge 2 aus dem nitridischen Verbindungshalbleitermaterial der Fall ist, erfolgt die vorzugsweise epitaktische Abscheidung des nitridischen Verbindungshalbleitermaterials bevorzugt derart, dass die Halbleiterschichtenfolge 2 bei einer Abscheidetemperatur bezüglich des Substrats 1 kompressiv verspannt ist, was auch als druckverspannt bezeichnet wird. Das heißt, dass das Verbindungshalbleitermaterial eine Gitterkonstante annimmt, die in der lateralen Ebene kleiner ist als eine intrinsische Gitterkonstante des Verbindungshalbleitermaterials. Beim Abkühlen der Halbleiterschichtenfolge 2 nach dem Aufwachsen ist so die Gefahr verringert, dass die Differenz der thermischen Ausdehnungskoeffizienten zwischen der Halbleiterschichtenfolge 2 und dem Substrat 1 Störungen in der Halbleiterschichtenfolge 2, beispielsweise Risse, zur Folge hat.

Um die Halbleiterschichtenfolge 2 und insbesondere den aktiven Bereich 21 kompressiv verspannt aufzuwachsen, weist die Halbleiterschichtenfolge 2 zwischen dem aktiven Bereich 21 und dem Substrat 1 den Zwischenbereich 22 auf, der an das Substrat 1 angrenzt. Auf der dem Substrat 1 abgewandten Seite des Zwischenbereichs 22 ist der aktive Bereich 21 ausgebildet.

Die Halbleiterschichten des Zwischenbereichs 22 dienen vorwiegend der Steigerung der Qualität der rein beispielhaft gezeigten Halbleiterschichten 23, 24, 25 des für den Betrieb des Halbleiterbauelements 100 maßgeblichen aktiven Bereichs 21.

Der Zwischenbereich 22 weist eine Nukleations- oder Ankeimschicht 26, eine Übergangsschicht 27 und eine Verspannungsschicht 28 auf, die nacheinander auf dem Substrat 1 abgeschieden werden.

Die an das Substrat 1 angrenzende Nukleationsschicht 26 basiert auf einem AlN-Verbindungshalbleitermaterial und ist im gezeigten Ausführungsbeispiel insbesondere aus AlN. Die Nukleationsschicht 26 dient der Bekeimung des Substrats 1 und weist eine Dicke zwischen 50 nm und 300 nm, beispielsweise 200 nm, auf.

Im gezeigten nicht beanspruchten Ausführungsbeispiel der Figur 1 für das Halbleiterbauelement 100 ist die Nukleationsschicht 26 als zumindest eine Zwischenschicht 3 aus sauerstoffdotiertem AlN-Verbindungshalbleitermaterial ausgebildet. Dazu ist die Nukleationsschicht mit einem Sauerstoffgehalt von größer oder gleich 0,1% und kleiner oder gleich 5%, bevorzugt von größer oder gleich 1%, dotiert. Es hat sich gezeigt, dass der beispielsweise 4 µm dicke aktive Bereich 21, der im gezeigten Ausführungsbeispiel aus einem GaN-basierten nitridischen Verbindungshalbleitermaterial aufgebaut ist, mit einer verbesserten kristallinen Qualität und Homogenität aufgewachsen werden kann.

Zum Aufwachsen der Zwischenschicht 3 wird neben weiteren Ausgangsstoffen als sauerstoffhaltige Verbindung eine sauerstoffhaltige Metallorganylverbindung, insbesondere Diethylaluminiumethoxid (DEAlO), bereitgestellt. Die Erfinder haben herausgefunden, dass durch DEAlO als Ausgangsmaterial und zur Bereitstellung von Sauerstoff die Zwischenschicht 3 derart ausgebildet werden kann, dass der aktive Bereich 21 mit einer verbesserten Kristallqualität hergestellt werden kann.

Auf der als zumindest eine Zwischenschicht 3 aus einem sauerstoffdotierten AlN-Verbindungshalbleitermaterial ausgeführten Nukleationsschicht 26 ist die Übergangsschicht 27 basierend auf AlGaN aufgebracht, die eine Gesamtdicke von etwa 150 nm im gezeigten Ausführungsbeispiel aufweist. Die Übergangsschicht 27 ist dabei als Schichtenfolge ausgeführt, die eine Mehrzahl von Schichten aufweist, in denen schrittweise oder kontinuierlich der Galliumgehalt in Aufwachsrichtung erhöht wird.

Die Verspannungsschicht 28 auf der Übergangsschicht 27 dient der Ausbildung einer kompressiven Verspannung bei der Abscheidetemperatur der Halbleiterschichtenfolge 2. Beim Abkühlen nach dem Aufwachsen der Halbleiterschichtenfolge 2 kann diese kompressive Verspannung durch den Unterschied der thermischen Ausdehnungskoeffizienten zwischen dem Substrat 1 und der Halbleiterschichtenfolge 2 verursachte Zugverspannungen vollständig oder zumindest teilweise kompensieren. Die Verspannungsschicht 28 weist dazu eine oder mehrere GaN-Schichten auf, die in eine oder mehrere AlGaN-Schichten, beispielsweise zwei bis drei AlGaN-Schichten, eingebettet sind. Dazu werden die AlGaN-Schichten beispielsweise mit einer Dicke von etwa 20 nm aufgewachsen und mit den GaN-Schichten überwachsen, so dass sich eine abwechselnde Abfolge der AlGaN- und der GaN-Schichten ergibt. Die Dicke der Verspannungsschicht 28 liegt bevorzugt in einem Bereich von größer oder gleich 2 µm und kleiner oder gleich 3 µm, beispielsweise 2,5 µm.

Der Zwischenbereich 22 ist weitgehend unabhängig von dem nachfolgenden aktiven Bereich 21 und kann daher auch für andere optoelektronische oder elektronische Bauelemente Anwendung finden.

In Figur 2 ist ein Ausführungsbeispiel gemäß der vorliegenden Erfindung für ein Halbleiterbauelement 200 gezeigt.

Im Vergleich zum Halbleiterbauelement 100 gemäß dem nicht beanspruchten Ausführungsbeispiel in Figur 1 weist das Halbleiterbauelement 200 eine Übergangsschicht 27 auf, die als Schichtenfolge ausgebildet ist, die zumindest eine Zwischenschicht 3 aus einem sauerstoffdotierten AlN-Verbindungshalbleitermaterial, beispielsweise ALN oder AlGaN, aufweist. Die Zwischenschicht 3 kann dabei, wie im gezeigten Ausführungsbeispiel dargestellt, innerhalb der Übergangsschicht 27 angeordnet sein oder auch alternativ dazu beispielsweise als erste Schicht der Übergangsschicht 27 direkt auf der Nukleationsschicht 26.

Weiterhin können beispielsweise auch alle Schichten der Übergangsschicht 27 auf einem sauerstoffdotierten AlN-Verbindungshalbleitermaterial basieren und beispielsweise sauerstoffdotiertes AlGaN aufweisen.

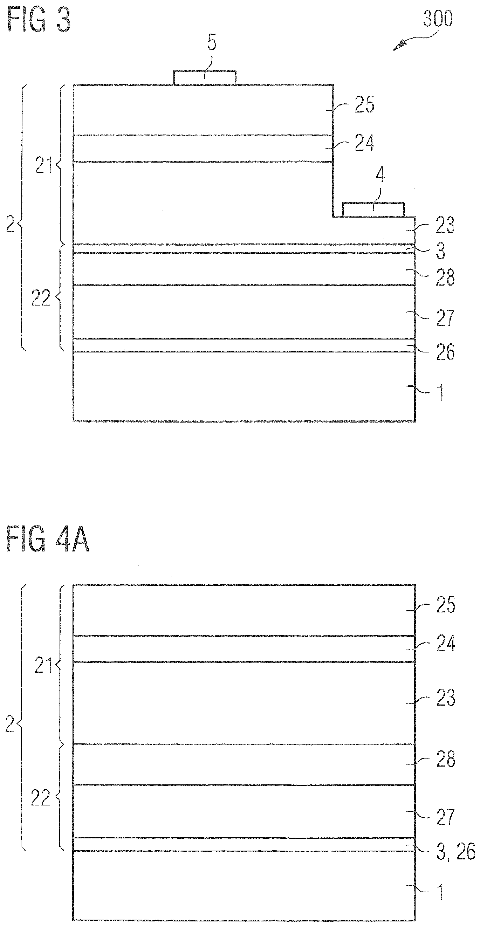

In Figur 3 ist ein weiteres Ausführungsbeispiel für ein Halbleiterbauelement 300 gezeigt, bei dem im Vergleich zu den beiden vorherigen Ausführungsbeispielen eine Zwischenschicht 3 aus einem sauerstoffdotierten AlN-Verbindungshalbleitermaterial zwischen dem aktiven Bereich 21 und der Übergangsschicht 27, insbesondere direkt angrenzend an den aktiven Bereich 21, angeordnet ist. Die Zwischenschicht 3 weist dabei im gezeigten Ausführungsbeispiel eine Dicke von lediglich 20 nm auf. Es hat sich gezeigt, dass sich durch eine derartige Zwischenschicht 3, die als abschließende Schicht des Zwischenbereichs 22 aufgebracht wird, die Kristallqualität des aktiven Bereichs 21 deutlich verbessern lässt.

Alternativ zu den gezeigten Ausführungsbeispielen der Figuren 1 bis 3 mit jeweils einer Zwischenschicht 3 können die gezeigten Halbleiterbauelemente 100, 200, 300 jeweils auch eine Mehrzahl von Zwischenschichten aus sauerstoffdotiertem AlN-Verbindungshalbleitermaterial aufweisen. Insbesondere sind auch Halbleiterbauelemente denkbar, die Kombinationen der gezeigten Ausführungsbeispiele aufweisen.

In den Figuren 4A bis 4C ist ein Ausführungsbeispiel für ein Verfahren zur Herstellung eines Halbleiterbauelements 400 gezeigt.

Dazu wird in einem ersten Verfahrensschritt gemäß Figur 4A eine Halbleiterschichtenfolge 2, basierend auf einem nitridischen Verbindungshalbleitermaterial, auf einem Substrat 1 mit einer Silizium-Oberfläche aufgebracht. Das Aufbringen erfolgt dabei im gezeigten Ausführungsbeispiel mittels epitaktischen Wachstums durch ein MOVPE- oder MBE-Verfahren. Im gezeigten Ausführungsbeispiel ist die Halbleiterschichtenfolge mit dem aktiven Bereich 21 und dem Zwischenbereich 22 wie im Ausführungsbeispiel gemäß der Figur 1 ausgebildet. Alternativ dazu kann die Halbleiterschichtenfolge 2 auch Merkmale gemäß der weiteren Ausführungsbeispiele und/oder gemäß der Ausführungsformen im allgemeinen Teil aufweisen.

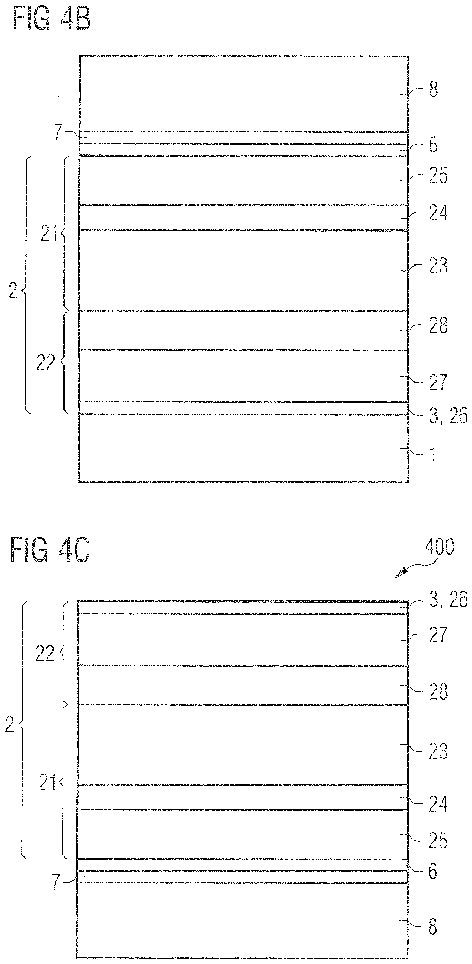

Nach dem Aufbringen der Halbleiterschichtenfolge 2 wird diese zur Herstellung von Dünnfilm-Halbleiterchips entsprechend der folgenden Verfahrensschritte weiterverarbeitet. Wie in Figur 4B dargestellt wird dazu auf dem aktiven Bereich 21 mittels einer Verbindungsschicht 7, beispielsweise einem Lot oder einer elektrisch leitfähigen Klebeschicht, ein Trägersubstrat 8 befestigt. Das Trägersubstrat 8 muss dabei nicht die hohen kristallinen Eigenschaften eines Aufwachssubstrats aufweisen und kann beispielsweise auch hinsichtlich anderer geeigneter Eigenschaften gewählt werden, etwa im Hinblick auf eine hohe thermische Leitfähigkeit. Für das Trägersubstrat 8 eignen sich beispielsweise ein Halbleitermaterial wie etwa Silizium, Germanium oder Galliumarsenid oder auch ein Keramikmaterial wie etwa Aluminiumnitrid oder Bornitrid.

Vor dem Aufbringen des Trägersubstrats 8 mittels der Verbindungsschicht 7 wird auf dem aktiven Bereich 21 eine Spiegelschicht 6 aufgebracht. Die Spiegelschicht 6 dient dabei der Reflexion der im Betrieb des später fertiggestellten Halbleiterbauelements in der aktiven Schicht 24 erzeugten Strahlung. Die Spiegelschicht 7 weist besonders bevorzugt ein Metall mit einer hohen Reflektivität für die in der aktiven Schicht 24 erzeugte Strahlung oder eine entsprechende metallische Legierung auf. Im sichtbaren Spektralbereich eignen sich insbesondere Aluminium, Silber, Rhodium, Palladium, Nickel und/oder Chrom oder auch Legierungen und/oder Schichtenfolgen davon.

Das Trägersubstrat 8 dient mit Vorteil der mechanischen Stabilisierung der Halbleiterschichtenfolge 2. Das Substrat 1 mit der Silizium-Oberfläche ist hierfür nicht mehr erforderlich und kann, wie in Figur 4C gezeigt, entfernt werden oder auch gedünnt werden. Dies kann beispielsweise nasschemisch, trockenchemisch oder durch ein mechanisches Verfahren wie etwa Schleifen, Polieren oder Läppen erfolgen. Alternativ oder zusätzlich kann das Ausdünnen oder Entfernen des Substrats 1 auch durch Einstrahlung vorzugsweise kohärenter Strahlung ermöglicht werden.

Ein Halbleiterbauelement, bei dem ein Aufwachssubstrat ausgedünnt oder entfernt ist, wird auch als Dünnfilm-Halbleiterbauelement bezeichnet.

Beispielsweise kann ein Leuchtdioden-Chip als Dünnfilm-Halbleiterbauelement ausgebildet sein und sich insbesondere durch mindestens eines der folgenden charakteristischen Merkmale auszeichnen:
- an einer zu dem Trägersubstrat hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurück reflektiert;
- die Epitaxieschichtenfolge weist eine Dicke im Bereich von 20 µm oder weniger, insbesondere im Bereich von 10 µm oder weniger, auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichts in der epitaktischen Epitaxieschichtenfolge führt, d. h. sie weist ein möglichst ergodisches stochastisches Streuverhalten auf.

Ein Grundprinzip eines Dünnschicht-Leuchtdiodenchips ist beispielsweise in I. Schnitzer et al., Applied Physics Letters 63(16), 18. Oktober 1993, Seiten 2174-2176 beschrieben, deren Offenbarungsgehalt insofern hiermit durch Rückbezug aufgenommen wird.

Nach dem Entfernen oder Dünnen des Substrats 1 kann die dem Trägersubstrat 8 abgewandte Oberfläche der Halbleiterschichtenfolge 2 beispielsweise noch mit einer Strukturierung, beispielsweise einer Aufrauung, versehen werden (nicht gezeigt). Die Auskoppeleffizienz für die in der aktiven Schicht 24 erzeugte Strahlung kann so gesteigert werden. Die Aufrauung beziehungsweise die Strukturierung kann sich dabei derart in den Zwischenbereich 22 erstrecken, dass dieser zumindest teilweise entfernt ist. Beispielsweise können die Nukleationsschicht 26 und die Übergangsschicht 27 teilweise oder sogar vollständig entfernt werden, sodass die Strukturierung in der Verspannungsschicht 28 ausgebildet werden kann.

Für die Injektion von Ladungsträgern in die aktive Schicht 24 können weiterhin noch Kontakte, etwa mittels Aufdampfens oder Aufsputterns, aufgebracht werden (nicht gezeigt).

Das Trägersubstrat 8 mit dem aktiven Bereich 21 kann weiterhin in einzelne Halbleiterbauelemente 400 vereinzelt werden.

Weiterhin kann es auch möglich sein, dass vor dem Aufbringen des Trägersubstrats 8 in die Halbleiterschichtenfolge 2, insbesondere in den aktiven Bereich 21, Kontaktstrukturen eingebracht werden, die im später fertiggestellten Halbleiterbauelement 400 eine Kontaktierung der aktiven Schicht beidseitig ermöglichen, wobei elektrische Kontakte nur auf einer Seite des aktiven Bereichs 21 angeordnet werden müssen.

Die hier beschriebenen Halbleiterbauelemente, bei denen eine Halbleiterschichtenfolge 2 auf einer Silizium-Oberfläche eines Substrats 1 aufgewachsen ist, zeichnen sich durch eine verbesserte Kristallqualität des aktiven Bereichs 21 aus, der insbesondere beispielsweise durch reduzierte Halbwertsbreiten kristallografischen Röntgenreflexen, gemessen als so genannte Rocking-Kurven, beispielsweise der (002)-, (102)- und (201)-Reflexe, nachweisen lässt.

Die Erfindung ist nicht durch die Beschreibung anhand der Ausführungsbeispiele beschränkt. Vielmehr umfasst die Erfindung jede Kombination von Merkmalen in den Patentansprüchen.

## Patentansprüche

1. Halbleiterbauelement mit einer Halbleiterschichtenfolge (2) aus einem nitridischen Verbindungshalbleitermaterial auf einem Substrat (1), wobe
i das Substrat (1) eine der Halbleiterschichtenfolge (2) zugewandte Silizium-Oberfläche aufweist,
wobei die Halbleiterschichtenfolge (2) einen aktiven Bereich (21) und zwischen dem Substrat (1) und dem aktiven Bereich (21) zumindest eine Zwischenschicht (3) aus einem sauerstoffdotierten AlN-Verbindungshalbleitermaterial aufweist und
wobei die zumindest eine Zwischenschicht (3) eine Übergangsschicht (27) oder Teil einer Übergangsschicht (27) zwischen dem aktiven Bereich (21) und einer Nukleationsschicht (26) ist oder die zumindest eine Zwischenschicht (3) zwischen einer Übergangsschicht (27) und dem aktiven Bereich (21) angeordnet ist,
**dadurch gekennzeichnet dass** der Sauerstoffgehalt der Zwischenschicht (3) größer oder gleich 1 % und kleiner oder gleich 5 % ist.

2. Halbleiterbauelement nach Anspruch 1, wobei die Zwischenschicht (3) eine Dicke von größer oder gleich 5 nm und kleiner oder gleich 300 nm aufweist.

3. Halbleiterbauelement nach einem der vorherigen Ansprüche, wobei die zumindest eine Zwischenschicht (3) eine Übergangsschicht (27) oder Teil einer Übergangsschicht (27) zwischen dem aktiven Bereich (21) und einer Nukleationsschicht (26) ist und zwischen dem aktiven Bereich (21) und der Nukleationsschicht (26) als Übergangsschicht (27) oder Teil der Übergangsschicht (27) eine Mehrzahl von Zwischenschichten (3) angeordnet ist.

4. Halbleiterbauelement nach einem der vorherigen Ansprüche, wobei die zumindest eine Zwischenschicht (3) direkt an den aktiven Bereich (21) angrenzt.

5. Halbleiterbauelement nach einem der vorherigen Ansprüche, wobei die Zwischenschicht (3) eine Dicke von 20 nm aufweist.

6. Halbleiterbauelement nach einem der vorherigen Ansprüche, wobei die Silizium-Oberfläche eine (111)-Ebene ist.

7. Halbleiterbauelement nach einem der vorherigen Ansprüche, wobei das Substrat (1) ein Silizium-Volumen-Substrat ist.

8. Verfahren zur Herstellung eines Halbleiterbauelements, bei dem auf einem Substrat (1) eine Halbleiterschichtenfolge (2) aus einem nitridischen Verbindungshalbleitermaterial aufgebracht wird,
wobei das Substrat (1) eine der Halbleiterschichtenfolge (2) zugewandte Silizium-Oberfläche aufweist,
wobei die Halbleiterschichtenfolge (2) mit einem aktiven Bereich (21) und zumindest einer Zwischenschicht (3) aus einem sauerstoffdotierten AlN-Verbindungshalbleitermaterial zwischen dem Substrat (1) und dem aktiven Bereich (21) aufgebracht wird,
wobei die zumindest eine Zwischenschicht (3) eine Übergangsschicht (27) oder Teil einer Übergangsschicht (27) zwischen dem aktiven Bereich (21) und einer Nukleationsschicht (26) ist oder die zumindest eine Zwischenschicht (3) zwischen einer Übergangsschicht (27) und dem aktiven Bereich (21) angeordnet ist,
dadurch charakterisiert dass der Sauerstoffgehalt der Zwischenschicht (3) größer oder gleich 1% und kleiner oder gleich 5% ist.

9. Verfahren nach Anspruch 8, bei dem zur Herstellung der Zwischenschicht (3) eine sauerstoffhaltige Metallorganylverbindung bereitgestellt wird.

10. Verfahren nach Anspruch 9, bei dem die sauerstoffhaltige Metallorganylverbindung Diethylaluminiumethoxid ist.

11. Verfahren nach einem der Ansprüche 8 bis 10, bei dem das Substrat (1) nach dem Aufbringen der Halbleiterschichtenfolge (2) zumindest bereichsweise entfernt oder gedünnt wird.

## Claims

1. A semiconductor component comprising a semiconductor layer sequence (2) composed of a nitridic compound semiconductor material on a substrate (1),
wherein the substrate (1) has a silicon surface facing the semiconductor layer sequence (2),
wherein the semiconductor layer sequence (2) has an active region (21) and at least one intermediate layer (3) composed of an oxygen-doped AlN compound semiconductor material between the substrate (1) and the active region (21) and
wherein the at least one intermediate layer (3) is a transition layer (27) or part of a transition layer (27) between the active region (21) and a nucleation layer (26) or the at least one intermediate layer (3) is arranged between the transition layer (27) and the active region (21),
**characterized in that** the oxygen content of the intermediate layer (3) is greater than or equal to 1% and less than or equal to 5%.

2. The semiconductor component according to claim 1,
wherein the intermediate layer (3) has a thickness of greater than or equal to 5 nm and less than or equal to 300 nm.

3. The semiconductor component according to any of the preceding claims, wherein the at least one intermediate layer (3) is a transition layer (27) or part of a transition layer (27) between the active region (21) and a nucleation layer (26) and a plurality of intermediate layers (3) are arranged between the active region (21) and the nucleation layer (26) as a transition layer (27) or part of the transition layer (27).

4. The semiconductor component according to any of the preceding claims, wherein the at least one intermediate layer (3) directly adjoins the active region (21).

5. The semiconductor component according to any of the preceding claims, wherein the intermediate layer (3) has a thickness of 20 nm.

6. The semiconductor component according to any of the preceding claims, wherein the silicon surface is a (111) plane.

7. The semiconductor component according to any of the preceding claims, wherein the substrate (1) is a silicon bulk substrate.

8. A method for producing a semiconductor component,
wherein a semiconductor layer sequence (2) composed of a nitridic compound semiconductor material is applied on a substrate (1),
wherein the substrate (1) has a silicon surface facing the semiconductor layer sequence (2),
wherein the semiconductor layer sequence (2) having an active region (21) and at least one intermediate layer (3) composed of an oxygen-doped AlN compound semiconductor material is applied between the substrate (1) and the active region (21), whe
rein the at least one intermediate layer (3) is a transition layer (27) or part of a transition layer (27) between the active region (21) and a nucleation layer (26) or the at least one intermediate layer (3) is arranged between the transition layer (27) and the active region (21),
**characterized in that** the oxygen content of the intermediate layer (3) is greater than or equal to 1% and less than or equal to 5%.

9. The method according to claim 8, wherein an oxygen-containing metal organyl compound is provided for producing the intermediate layer (3).

10. The method according to claim 9, wherein the oxygen-containing metal organyl compound is diethylaluminum ethoxide.

11. The method according to any of claims 8 to 10, wherein the substrate (1) is removed or thinned at least in regions after the semiconductor layer sequence (2) has been applied.

## Revendications

1. Composant semi-conducteur comprenant une succession de couches semi-conductrices (2) d'un matériau de connexion semi-conducteur à base de nitrure sur un substrat (1),
le substrat (1) présentant une surface de silicium dirigée vers la succession de couches semi-conductrices (2),
la succession de couches semi-conductrices (2) comprenant une zone active (21) et, entre le substrat (1) et la zone active (21), au moins une couche intermédiaire (3) d'un matériau de connexion semi-conducteur AlN dopé à l'oxygène et
au moins une couche intermédiaire (3) étant une couche de transition (27) ou une partie d'une couche de transition (27) entre la zone active (21) et une couche de nucléation (26), ou au moins une couche intermédiaire (3) étant disposée entre une couche de transition (27) et la zone active (21),
**caractérisé en ce que**
la teneur en oxygène de la couche intermédiaire (3) est supérieure ou égale à 1 % et inférieure ou égale à 5 %.

2. Composant semi-conducteur selon la revendication 1, dans lequel la couche intermédiaire (3) présente une épaisseur supérieure ou égale à 5 nm et inférieure ou égale à 300 nm.

3. Composant semi-conducteur selon l'une des revendications précédentes, dans lequel au moins une couche intermédiaire (3) est une couche de transition (27) ou une partie d'une couche de transition (27) entre la zone active (21) et une couche de nucléation (26) et plusieurs couches intermédiaires (3) sont disposées entre la zone active (21) et la couche de nucléation (26) en tant que couche de transition (27) ou partie de la couche de transition (27).

4. Composant semi-conducteur selon l'une des revendications précédentes, dans lequel au moins une couche intermédiaire (3) est directement adjacente à la zone active (21).

5. Composant semi-conducteur selon l'une des revendications précédentes, dans lequel la couche intermédiaire (3) présente une épaisseur de 20 nm.

6. Composant semi-conducteur selon l'une des revendications précédentes, dans lequel la surface de silicium est un plan (111).

7. Composant semi-conducteur selon l'une des revendications précédentes, dans lequel le substrat (1) est un substrat en volume de silicium.

8. Procédé de fabrication d'un composant semi-conducteur, dans lequel une succession de couches semi-conductrices (2) constituée d'un matériau de connexion semi-conducteur à base de nitrure est appliquée sur un substrat (1),
le substrat (1) présentant une surface de silicium dirigée vers la succession de couches semi-conductrices (2),
la succession de couches semi-conductrices (2) comportant une zone active (21) et au moins une couche intermédiaire (3) d'un matériau de connexion semi-conducteur AlN dopé à l'oxygène étant appliquée entre le substrat (1) et la zone active (21), et
au moins une couche intermédiaire (3) étant une couche de transition (27) ou une partie d'une couche de transition (27) entre la zone active (21) et une couche de nucléation (26) ou au moins une couche intermédiaire (3) étant disposée entre une couche de transition (27) et la zone active (21),
**caractérisé en ce que** la teneur en oxygène de la couche intermédiaire (3) est supérieure ou égale à 1 % et inférieure ou égale à 5 %.

9. Procédé selon la revendication 8, comprenant la fourniture d'un composé organyle métallique contenant de l'oxygène pour former la couche intermédiaire (3).

10. Procédé selon la revendication 9, dans lequel le composé organyle métallique contenant de l'oxygène est de l'éthoxyde de diéthylaluminium.

11. Procédé selon l'une des revendications 8 à 10, dans lequel le substrat (1) est enlevé ou aminci au moins par zones après l'application de la succession de couches semi-conductrices (2).
